# EUROPÄISCHE PATENTSCHRIFT

(11) **EP 2 513 995 B1**
(45) Veröffentlichungstag und Bekanntmachung des Hinweises auf die Patenterteilung: **11.05.2016**
(21) Anmeldenummer: 10787817.5
(22) Anmeldetag: 15.12.2010
(51) Int. Cl.: H01L 51/44

(54) **PHOTOAKTIVES BAUELEMENT MIT ORGANISCHEN SCHICHTEN**
PHOTOACTIVE COMPONENT HAVING ORGANIC LAYERS
COMPOSANT PHOTOACTIF À COUCHES ORGANIQUES

(30) Priorität: 16.12.2009 DE 102009058635
(43) Veröffentlichungstag der Anmeldung: 24.10.2012
(73) Patentinhaber: Heliatek GmbH, 01139 Dresden (DE)
(72) Erfinder: MÄNNIG, Bert, 01099 Dresden (DE); SCHWARTZ, Gregor, East Palo Alto California 94303 (US); UHRICH, Christian, 01307 Dresden (DE)
(86) Internationale Anmeldenummer: PCT/EP2010/069679
(87) Internationale Veröffentlichungsnummer: WO 2011/073219

(56) Entgegenhaltungen:
- EP-A2- 2 256 839
- WO-A1-2009/153328
- US-A1- 2002 017 612
- US-A1- 2004 016 923
- US-A1- 2006 059 705
- US-A1- 2008 236 657
- US-B1- 6 300 612

## Beschreibung

Die Erfindung betrifft ein organisches photoaktives Bauelement, speziell eine organische Solarzelle, mit einer Elektrode auf dem Substrat und einer Top-Gegenelektrode und zwischen den Elektroden eine dotierte Transportschicht und ein photoaktives Schichtsystem, dadurch gekennzeichnet, dass sich zwischen dem photoaktiven System und der Topgegenelektrode eine Metalloxidschicht befindet.

Seit der Demonstration der ersten organischen Solarzelle mit einem Wirkungsgrad im Prozentbereich durch Tang et al. 1986 [C.W. Tang et al. Appl. Phys. Lett. 48, 183 (1986)], werden organische Materialien intensiv für verschiedene elektronische und optoelektronische Bauelemente untersucht. Organische Solarzellen bestehen aus einer Folge dünner Schichten (typischerweise 1nm bis 1µm) aus organischen Materialien, welche bevorzugt im Vakuum aufgedampft oder aus einer Lösung aufgeschleudert werden. Die elektrische Kontaktierung kann durch Metallschichten, transparente leitfähige Oxide (TCOs) und/oder transparente leitfähige Polymere (PEDOT-PSS, PANI) erfolgen.

Eine Solarzelle wandelt Lichtenergie in elektrische Energie um. Der Begriff photoaktiv bezeichnet hierbei ebenfalls die Umwandlung von Lichtenergie in elektrische Energie. Im Gegensatz zu anorganische Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluß beitragen.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2x105 cm-1), so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie.

Eine in der Literatur bereits vorgeschlagene Realisierungsmöglichkeit einer organischen Solarzelle besteht in einer pin -Diode [Martin Pfeiffer, "Controlled doping of organic vacuum deposited dye layers: basics and applications", PhD thesis TU-Dresden, 1999.] mit folgendem Schichtaufbau:
0. Träger, Substrat,
1. Grundkontakt, meist transparent,
2. p- Schicht(en),
3. i- Schicht(en),
4. n- Schicht(en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. Es ist allerdings auch möglich, dass die n-Schicht(en) bzw. p-Schicht(en) zumindest teilweise nominell undotiert sind und nur aufgrund der Materialeigenschaften (z.B. unterschiedliche Beweglichkeiten), aufgrund unbekannter Verunreinigungen (z.B. verbliebene Reste aus der Synthese, Zerfalls- oder Reaktionsprodukte während der Schichtherstellung) oder aufgrund von Einflüssen der Umgebung (z.B. angrenzende Schichten, Eindiffusion von Metallen oder anderen organischen Materialien, Gasdotierung aus der Umgebungsatmosphäre) bevorzugt n-leitende bzw. bevorzugt p-leitende Eigenschaften besitzen. In diesem Sinne sind derartigen Schichten primär als Transportschichten zu verstehen. Die Bezeichnung i-Schicht bezeichnet demgegenüber eine nominell undotierte Schicht (intrinsische Schicht). Eine oder mehrere i-Schichten können hierbei Schichten sowohl aus einem Material, als auch eine Mischung aus zwei Materialien (sogenannte interpenetrierende Netzwerke bzw. bulk-heterojunction; M. Hiramoto et al. Mol. Cryst. Liq. Cryst., 2006, 444, pp. 33-40) bestehen. Das durch den transparenten Grundkontakt einfallende Licht erzeugt in der i-Schicht bzw. in der n-/p-Schicht Exzitonen (gebundene Elektron-Loch-Paare). Diese Exzitonen können nur durch sehr hohe elektrische Felder oder an geeigneten Grenzflächen getrennt werden. In Organische Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen. Die Exzitonen gelangen durch Diffusion an eine derartige aktive Grenzfläche, wo Elektronen und Löcher voneinander getrennt werden. Das Material, welches die Elektronen aufnimmt, wird dabei als Akzeptor, und das Material, welches das Loch aufnimmt, als Donator (oder Donor) bezeichnet. Die trennende Grenzfläche kann zwischen der p- (n-) Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert. Vorzugsweise handelt es sich bei den Transportschichten um transparente oder weitgehend transparente Materialien mit großer Bandlücke (wide-gap) wie sie z.B. in WO 2004083958 beschrieben sind. Als wide-gap Materialien werden hierbei Materialien bezeichnet, deren Absorptionsmaximum im Wellenlängenbereich <450nm liegt, vorzugsweise bei <400nm.

Da durch das Licht immer erst Exzitonen erzeugt werden und noch keine freien Ladungsträger, spielt die rekombinationsarme Diffusion von Exzitonen an die aktive Grenzfläche eine kritische Rolle bei Organische Solarzellen. Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann. Strukturell und bezüglich der chemischen Reinheit perfekte organische Kristalle oder Dünnschichten erfüllen durchaus dieses Kriterium. Für großflächige Anwendungen ist allerdings die Verwendung von monokristallinen organischen Materialien nicht möglich und die Herstellung von Mehrfachschichten mit ausreichender struktureller Perfektion ist bis jetzt noch sehr schwierig.

Falls es sich bei der i-Schicht um eine Mischschicht handelt, so übernimmt die Aufgabe der Lichtabsorption entweder nur eine der Komponenten oder auch beide. Der Vorteil von Mischschichten ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in den jeweiligen Materialien. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind.

Aus der US 5,093,698 ist die Dotierung organischer Materialien bekannt. Durch Beimischung einer akzeptorartigen bzw. donatorartigen Dotiersubstanz wird die Gleichgewichtsladungsträgerkonzentration in der Schicht erhöht und die Leitfähigkeit gesteigert. Nach US 5,093,698 werden die dotierten Schichten als Injektionsschichten an der Grenzfläche zu den Kontaktmaterialien in elektrolumineszierenden Bauelementen verwendet. Ähnliche Dotierungsansätze sind analog auch für Solarzellen zweckmäßig.

Aus der Literatur sind verschiedene Realisierungsmöglichkeiten für die photoaktive i-Schicht bekannt. So kann es sich hierbei um eine Doppelschicht (EP0000829) oder eine Mischschicht (Hiramoto, Appl. Phys.Lett. 58,1062 (1991)) handeln. Bekannt ist auch eine Kombination aus Doppel-und Mischschichten (Hiramoto, Appl. Phys.Lett. 58,1062 (1991); US 6,559,375). Ebenfalls bekannt ist, dass das Mischungsverhältnis in verschiedenen Bereichen der Mischschicht unterschiedlich ist (US 20050110005) bzw. das Mischungsverhältnis einen Gradienten aufweist.

Weiterhin sind Tandem- bzw. Mehrfachsolarzellen aus der Literatur bekannt (Hiramoto, Chem. Lett.,1990, 327 (1990); DE 102004014046).

Aus der Literatur schon lange bekannt sind organische Tandemsolarzellen (Hiramoto, Chem. Lett.,1990, 327 (1990). In der Tandemzelle von Hiramoto et al. befindet sich eine 2nm dicke Goldschicht zwischen den beiden Einzelzellen. Die Aufgabe dieser Goldschicht besteht darin für eine gute elektrische Verbindung zwischen den beiden Einzelzellen zu sorgen: die Goldschicht bewirkt eine effiziente Rekombination der Löcher aus der einen Teilzelle mit den Elektronen aus der anderen Teilzelle und bewirkt damit, dass die beiden Teilzellen elektrisch in Serie verschaltet sind. Weiterhin absorbiert die Goldschicht wie jede dünne Metallschicht (bzw. Metallcluster) einen Teil des einfallenden Lichts. Diese Absorption ist in der Tandemzelle von Hiramoto ein Verlustmechanismus, da dadurch den photoaktiven Schichten (H2Pc (metallfreies Phthalocyanin) / Me-PTC (N,N"-dimethylperylene-3,4,9,10-bis(dicarboximide) in den beiden Einzelzellen der Tandemzelle weniger Licht zur Verfügung steht. Die Aufgabe der Goldschicht ist in dieser Tandemstruktur daher rein auf der elektrischen Seite.

Innerhalb dieser Konzeption sollte die Goldschicht möglichst dünn sein bzw. im besten Fall komplett wegfallen.

Weiterhin aus der Literatur bekannt sind organische pin-Tandemzellen (DE 102004014046): Die Struktur solch einer Tandemzelle besteht aus zwei pin-Einzelzellen wobei die Schichtfolge "pin" die Abfolge aus einem p-dotierten Schichtsystem, einem undotierten photoaktiven Schichtsystem und einem n-dotierten Schichtsystem beschreibt. Die dotierten Schichtsysteme bestehen bevorzugt aus transparenten Materialien, so genannten wide-gap Materialien/Schichten und sie können hierbei auch teilweise oder ganz undotiert sein oder auch ortsabhängig verschiedene Dotierungskonzentrationen aufweisen bzw. über einen kontinuierlichen Gradienten in der Dotierungskonzentration verfügen. Speziell auch sehr gering dotierte oder hochdotierte Bereiche im Grenzbereich an den Elektroden, im Grenzbereich zu einer anderen dotierten oder undotierten Transportschicht, im Grenzbereich zu den aktiven Schichten oder bei Tandem- oder Mehrfachzellen im Grenzbereich zu der anliegenden pin- bzw. nip- Teilzelle,d.h. im Bereich der Rekombinationszone sind möglich. Auch eine beliebige Kombination aus allen diesen Merkmalen ist möglich. Natürlich kann es sich bei einer solchen Tandemzelle auch um eine sogenannte invertierte Struktur (z.B. nip-Tandemzelle; handeln. Im Folgenden werden alle diese möglichen Tandemzellen-Realisierungsformen mit dem Begriff pin-Tandemzellen bezeichnet. Ein Vorteil einer solchen pin-Tandemzelle besteht darin, dass durch die Verwendung von dotierten Transportschichten eine sehr einfache und gleichzeitig sehr effiziente Realisierungsmöglichkeit für die Rekombinationszone zwischen den beiden Teilzellen möglich ist. Die Tandemzelle weist z.B. eine pinpin-Struktur auf (oder auch z.B. möglich nipnip). An der Grenzfläche zwischen den beiden pin-Teilzellen befinden sich jeweils eine n-dotierte Schicht und eine p-dotierte Schicht, die ein pn-System (bzw. np-System) bilden. In einem solchen dotierten pn-System erfolgt eine sehr effiziente Rekombination der Elektronen und Löcher. Die Stapelung von zwei pin-Einzelzellen ergibt damit direkt eine vollständige pin-Tandemzelle, ohne dass noch weitere Schichten benötigt werden. Speziell von Vorteil ist hier, dass keine dünnen Metallschichten mehr benötigt werden wie bei Hiramoto, um die effiziente Rekombination zu gewährleisten. Hierdurch kann die Verlustabsorption solcher dünnen Metallschichten komplett vermieden werden.

Das zentrale Problem bei der Effizienz-Optimierung von Tandemzellen besteht darin, dass beide Teilzellen möglichst gleich viel Photostrom erzeugen sollen. Da hocheffiziente organische Solarzellen über eine hohe interne Quanteneffizienz verfügen (fast alle Photonen werden in elektrischen Strom umgesetzt) bedeutet dies, dass beide Teilzellen möglichst gleich Licht (d.h. Anzahl an Photonen) des Sonnenspektrums absorbieren sollen. Falls nämlich eine Teilzelle mehr Licht absorbiert als die andere Teilzelle, so könnte die erstere eigentlich einen größeren Photostrom erzeugen als die zweite. Da in der Tandemzelle die beiden Teilzellen elektrisch in Serie verschaltet sind, wird der Strom der Tandemzelle allerdings immer durch den geringeren Strom einer der beiden Teilzellen limitiert. Der potentiell größere Strom einer Teilzelle, die mehr Licht absorbiert, muss damit ungenutzt bleiben. Tandemzellen müssen daher so optimiert werden, dass beide Teilzellen möglichst viel Licht absorbieren und gleich viel Licht absorbieren.

Die Ausbalancierung der Absorption kann z.B. über die Variation der Dicken der beiden photoaktiven Schichtsysteme erfolgen. Eine weitere Möglichkeit bei pin-Tandemzellen besteht darin, durch die Variation der Dicken der Transportschichten die photoaktiven Schichtsysteme in die Maxima der optischen Feldverteilung des Lichtes zu platzieren (dies ist ebenfalls in DE 102004014046 beschrieben).

Die Anpassungsmöglichkeiten durch diese beiden genannten Methoden sind allerdings beschränkt bzw. mit Verlust verbunden: so kann z.B. in einer Tandemzelle eine Gleichheit der Absorption dadurch erreicht werden, indem bei der "besseren" Teilzelle die Dicke des photoaktiven Systems reduziert wird und diese Teilzelle damit weniger Licht, nämlich genauso viel wie die andere, absorbiert. Somit hat man zwar nominell die Tandemzelle optimiert, allerdings hat dies auch nur dazu geführt, dass die "schwächere" Teilzelle das Bauelement wiederum limitiert und das Potential der "besseren" nicht genutzt werden kann. Weiterhin müssen Tandemzellen, die einen hohen Wirkungsgrad haben sollen, verschiedene Absorbersysteme beinhalten, d.h. die beiden Teilzellen enthalten mehrere verschiedene Absorbermaterialien und absorbieren teilweise oder ganz in verschiedenen spektralen Bereichen des Lichts. Die Verteilung der Absorptionsmaxima des Lichts innerhalb des Bauelementes ist aber abhängig von der Wellenlänge. Dies führt dazu, dass in diesem Fall die Optimierung der Dünnschichtoptik für jeden einzelnen Absorber in jeder der beiden Tandemzellen sehr kompliziert ist und nur eingeschränkt durch eine Variation der Dicken der Schichten erfolgen kann (da sich die verschiedenen Bedingungen für die einzelnen Absorber in der Regel nicht mit einem Satz von Schichtdicken gleichzeitig erfüllen lassen).

Ein weiteres Problem für die Anwendung besteht darin, dass Solarzellen an verschiedenen Orten und unter verschiedenen Bedingungen eingesetzt werden sollen und damit das Spektrum des Lichts für verschiedene Anwendungen verschieden ist. So entspricht z.B. das Lichtspektrum für die Anwendungen auf Dächern sehr gut dem Standard-Sonnenspektrum AM1.5 (für Mitteleuropa). Für Häuserfassaden integrierte Systeme in Städten (speziell innerhalb von engen Strassenschluchten) sind die Bedingungen allerdings bereits andere und spätestens bei Indoor-Anwendungen hängt das zur Verfügung stehende Licht komplett von der künstlichen Lichtquelle ab. Das Problem hiermit ist, dass die gesamte Optimierung der Tandemzellen immer nur für ein spezielles Lichtspektrum erfolgen kann. Für die Anwendungen ist es damit wichtig eine einfache und für die Produktion praktische Möglichkeit zu haben die Tandemzellen an verschiedene Lichtspektren anzupassen, ohne dass dafür für jede Anwendung der Aufbau der Tandemzelle stark geändert werden muss bzw. andere Absorbermaterialien eingesetzt werden müssen.

Ein weiteres Problem besteht neben der Optimierung der Lichtausbeute darin, dass die verwendeten organischen Solarzellen auf flexiblen Substraten, wie etwa Folien, aufgebracht werden sollen.

Das Problem dabei ist, dass es zwar sehr gute Verkapselungsmöglichkeiten gibt (z.B. Glas-Glas Verkapselung), dieser aber für viele Anwendungen zu teuer und oft nicht flexibel sind. Eine billige, möglichst flexible Verkapselung ist nicht perfekt, d.h. die schließt das Bauelement nicht hermetisch komplett ab, sondern z.B. Wasser und Sauerstoff dringen nach und nach in die Zelle ein. Daraus folgt als Anforderung an die Zelle, dass diese möglichst schon selbst sehr stabil gegenüber Luft und anderen Atmosphären sein soll. Ziel ist also die Lebensdauer zu erhöhen und eine verbesserte Stabilität durch eine entsprechende Verkapselung zu realisieren. Gleichzeitig soll eine kostengünstige Möglichkeit der Verlängerung der Lebensdauer organischer Solarzellen angegeben werden.

Aus der Literatur bekannt ist dass Metalloxidschichten als Kontaktschichten eingesetzt werden (Cattin et al., JOURNAL OF APPLIED PHYSICS 105, 034507 (2009); Kim et al. , APPLIED PHYSICS LETTERS 95, 093304 (2009). Hier werden allerdings keine erhöhte Stabilität der Bauelemente berichtet.

Die US 2007/0221926 A1 dagegen offenbart eine TiOx-Schicht, welche als Passivierungsschicht auf das organische Material eines photoaktiven, organischen Bauelements aufgebracht wurde und zu einer erhöhten Lebensdauer der Solarzelle führt.

US 2008 / 236 657 A1 offenbart in Fig. 1 eine organische photovoltaische Zelle (200) mit folgenden Schichten: Substrat (210) / Elektrode (220) / Lochblockierschicht (230) / photoaktive Schicht (240) / Lochträgerschicht (250) und eine Elektrode (260) / Substrat (270).
Der Erfindung liegt somit die Aufgabe zugrunde, ein photoaktives Bauelement anzugeben, dass die vorbeschriebenen Nachteile überwindet und dabei eine erhöhte Effizienz des Bauelementes und möglichst eine verbesserte Lebensdauer aufweist.
Die obige Diskussion gilt natürlich genauso für Dreifachsolarzellen und Solarzellen aus mehr als drei Teilzellen.
Erfindungsgemäß wird die Aufgabe durch Bereitstellung einer organischen Solarzelle nach Anspruch 1 sowie die Verwendung der organischen Solarzelle nach Anspruch 10 gelöst.
Bevorzugte Ausführungsformen werden in den Unteransprüchen beschrieben. Erfindungsgemäß zeichnet sich die organische Solarzelle dadurch aus, dass sich zwischen dem photoaktiven Schichtsystem und der Topgegenelektrode eine Passivierungsschicht bestehend aus Molybdänoxid oder aus ganz oder teilweise dotiertem Molybdänoxid befindet. Speziell bei luftsensitiven Elektrodenmaterialien (z.B. Al) dient die Molybdänoxidschicht hier zur Stabilisierung des Top-Elektrodenmaterials. Außerdem kann die Passivierungsschicht den Eintrag von Sauerstoff und Feuchtigkeit in das photoaktive Bauelement verhindern. Insbesondere wird der Eintrag in die organischen Schichten unterbunden. Dadurch wird eine Verlängerung der Lebensdauer des photoaktiven Bauelements realisiert.
In einer Ausführungsform der Erfindung wird innerhalb zumindest einer Zelle oder zumindest zwischen zwei benachbarten Zellen zumindest ein Kavitäts-Schichtsystem eingefügt, dass die optische Kavität des Bauelementes verändert. Die Bezeichnung Zelle wird hier synonym für eine Einfachzelle oder eine Teilzelle einer Tandem- bzw. Mehrfachzelle verwendet.

Das Kavitäts-Schichtsystem bzw. die Kavitäts-Schichtsysteme bewirken dabei, dass eine Teilzelle hinsichtlich ihrer Absorption gestärkt wird (insbesondere die Teilzelle, die auf Grund von ungenügenden Ladungsträgertransporteigenschaften innerhalb des photoaktiven Systems in ihrer (sinnvoll) verwendbaren Schichtdicke limitiert ist) und/ oder ermöglicht eine einfache Anpassung von Einfach, Tandem- oder Mehrfachzellen an das jeweilige Beleuchtungsspektrum der Anwendung.

Vorzugsweise wird dieses durch ein Schichtsystem erreicht, welches als teiltransparenter Spiegel funktioniert. Die Transparenz dieses Spiegels kann dabei wellenlängenabhängig sein. Hierdurch kann die Lichtverteilung innerhalb des Bauelementes wellenlängenabhängig optimiert werden und es kann erreicht werden, dass die verschiedenen Absorber in den Teilzellen sich in einer möglichst hohen Feldverteilung des von ihnen absorbierten Wellenlängenbereiches befinden.

Die Passivierungsschicht zwischen dem photoaktiven Schichtsystem und der Topgegenelektrode dient zur Stabilisierung des Top-Elektrodenmaterials, speziell bei luftsensitiven Elektrodenmaterialien (z.B. Al).

Die Top-Gegenelektrode besteht aus einem Metall (z.B. aber nicht beschränkt auf Ag, Au, Ti, Ni, Cr, Cu, Fe oder Kombinationen hieraus), einem transparenten leitfähigen Oxid (z.B. aber nicht beschränkt auf ITO, ZnO, ZnO:Al), aus einer dotierten organischen Schicht (z.B. kleine Moleküle, n-dotiertes C60 oder einem hochleitfähigen Rekombinationssystem eines pn-Schichtsystems), aus organischen Kristallen, einem leitfähigen Polymer (z.B. aber nicht beschränkt auf PEDOT:PSS), aus einem luftsensitiven Elektrodenmaterial (z.B. aber nicht beschränkt auf Al) oder aus Kombinationen der vorgenannten Materialien, wobei hier die Metalloxidschicht zur Stabilisierung des Top-Elektrodenmaterials dient.

Erfindungsgemäß besteht die Passivierungsschicht aus Molybdänoxid. Das Molybdänoxid wird hierbei mittels geeigneter Verfahren, wie Aufdampfen, Sputtern, etc. aufgebracht.

In einer Ausführungsform der Erfindung ist die Passivierungsschicht ganz oder teilweise dotiert.

In einer Ausführungsform der Erfindung hat die Top-Gegenelektrode oder ein Teil der Top-Gegenelektrode eine Streifen-, Grid- oder bus-bar-Struktur.

In einer Ausführungsform der Erfindung grenzt die Passivierungsschicht direkt an eine dotierte, teilweise dotierte oder undotierte Transportschicht.

In einer Ausführungsform der Erfindung bestehen die organischen Schichten zumindest teilweise aus kleinen Molekülen, zumindest teilweise aus Polymeren oder aus einer Kombination von kleinen Molekülen und Polymeren.

In einer weiteren Ausführungsform handelt es sich bei einem Kavitäts-Schichtsystem um ein Metallschichtsystem, welches dazu genutzt wird gezielt die optische Feldverteilung innerhalb der organischen Solarzelle zu ändern.

In einer weiteren Ausführungsform ist ein Kavitäts-Schichtsystem dadurch teiltransparent indem es nur auf einem Teil der Solarzellenfläche vorhanden ist.

In einer weiteren Ausführungsform ist ein Kavitäts-Schichtsystem für Licht einer bestimmten Polarisationsart transparent, während dieses Kavitäts-Schichtsystem Licht einer anderen Polarisationsart reflektiert.

In einer weiteren Ausführungsform ist mindestens ein Kavitäts-Schichtsystem von den photoaktiven Schichtsystemen durch mindestens eine Transportschicht getrennt.

In einer weiteren Ausführungsform ist ein Kavitäts-Schichtsystem im direkten Kontakt mit dem photoaktiven Schichtsystem oder befindet sich sogar ganz oder teilweise innerhalb des photoaktiven Schichtsystems.

In einer weiteren Ausführungsform des Bauelementes können auch zwischen mehreren oder auch allen Teilzellen solche Kavitäts-Schichtsysteme vorhanden sein.

In einer weiteren Ausführungsform des Bauelementes können die Kavitäts-Schichtsysteme alle gleich sein.

In einer weiteren Ausführungsform des Bauelementes können die Kavitäts-Schichtsysteme sich nur durch die Dicken der verwendeten Materialien unterscheiden.

In einer weiteren Ausführungsform des Bauelementes können zwei oder mehr der Kavitäts-Schichtsysteme zumindest teilweise aus verschiedenen Materialien bestehen.

In einer weiteren Ausführungsform des Bauelementes können alle Kavitäts-Schichtsysteme paarweise zumindest teilweise aus verschiedenen Materialen bestehen.

In einer weiteren bevorzugten Ausführungsform des Bauelementes bestehen die Kavitäts-Schichtsystem aus einer Metallschicht, beispielsweise aber nicht beschränkt auf Au, Ag, Al, Cr, Ni, Co, Cu, Ti, etc.

In einer weiteren Ausführungsform des Bauelementes bestehen die Kavitäts-Schichtsysteme aus zwei oder mehreren verschiedenen Metallschichten. Hierbei kann es sich um eine paarweise oder auch nicht paarweise verschiedene Kombination handeln.

In einer weiteren Ausführungsform des Bauelementes bilden die Kavitäts-Schichtsysteme ein Gitter. Die Dimension der Gitterstrukturierung kann bevorzugt im mm-Bereich, im µm-Bereich oder auch im Wellenlängenbereich des Lichts liegen.

In einer weiteren Ausführungsform des Bauelementes bilden die Kavitäts-Schichtsysteme ein Metallgitter, beispielsweise aber nicht beschränkt auf Au, Ag, Al, Cr, Ni, Co, Cu, Ti, etc.).

In einer weiteren Ausführungsform des Bauelementes bestehen die Kavitäts-Schichtsysteme aus Stäben oder Streifen. Die Dicke der Stäbe/Streifen bzw. die Abstände zwischen den Stäben/Streifen kann bevorzugt im mm-Bereich, im µm-Bereich oder auch im Wellenlängenbereich des Lichts liegen. Im letzteren Fall bildet das Kavitäts-Schichtsystem einen linearen Polarisationsfilter.

In einer weiteren Ausführungsform des Bauelementes bestehen die Kavitäts-Schichtsysteme aus Metallstäben oder Metallstreifen, beispielsweise aber nicht beschränkt auf Au, Ag, Al, Cr, Ni, Co, Cu, etc. Die Dicken und Abstände der Stäbe bzw. Streifen können dabei so gewählt werden, dass die Kavitäts-Schichtsysteme ein Polarisationsfilter bilden.

In einer weiteren Ausführungsform des Bauelementes bestehen die Kavitäts-Schichtsysteme aus Kreisen, Dreiecken, Vielecken, karoförmigen Flächen oder anderen geometrischen Flächen.

In einer weiteren Ausführungsform des Bauelementes bestehen die Kavitäts-Schichtsysteme aus Metallschichten, die Kreise, Dreiecke, Vielecke, karoförmige Flächen oder andere geometrischen Metallflächen bilden, beispielsweise aber nicht beschränkt auf Au, Ag, Al, Cr, Ni, Co, Cu, etc.

In einer weiteren Ausführungsform des Bauelementes bestehen die Kavitäts-Schichtsysteme aus Metallschichten, die "Bananenstrukturen" bilden. Bei den Bananenstrukturen sind beide spitzen Enden zum aktiven Schichtsystem hin ausgerichtet. Die Feldüberhöhung findet also bevorzugt in das aktive Schichtsystem hinein statt, was besonders vorteilhaft ist.

In einer weiteren Ausführungsform des Bauelementes bestehen die Kavitäts-Schichtsysteme aus Metallstrukturen, wobei die Oberflächen der Metallstrukturen mit einem organischen oder anorganischen Isolatormaterial, welches bevorzugt transparent ist, überzogen sind.

In einer weiteren Ausführungsform des Bauelementes bestehen die Kavitäts-Schichtsysteme aus einem dotierten, teilweise dotierten oder undotierten Metalloxidschichtsystem.

In einer weiteren Ausführungsform des Bauelementes bestehen die Kavitäts-Schichtsysteme aus einer, zwei oder mehreren verschiedenen dotierten, teilweise dotierten oder undotierten Metalloxidschichten (hierbei kann es sich um eine paarweise oder auch nicht paarweise verschiedene Kombination handeln).

In einer weiteren Ausführungsform des Bauelementes bestehen die Kavitäts-Schichtsysteme aus einer dotierten, teilweise dotierten oder undotierten organischen Schicht. Bei dem organischen Material kann es sich um Polymere, kleine Moleküle oder um Kombinationen aus beiden handeln.

Unter kleinen Molekülen werden im Sinne der vorliegenden Erfindung nicht-polymere organische Moleküle mit monodispersen Molmassen zwischen 100 und 2000 verstanden, die unter Normaldruck (Luftdruck der uns umgebenden Atmosphäre) und bei Raumtemperatur in fester Phase vorliegen. Insbesondere könnend diese kleinen Molekülen auch photoaktiv sein, wobei unter photoaktiv verstanden wird, dass die Moleküle unter Lichteinfall ihren Ladungszustand ändern.

In einer weiteren Ausführungsform der Erfindung handelt es sich bei den verwendeten organischen Materialien zumindest teilweise um Polymere.

In einer weiteren Ausführungsform des Bauelementes bestehen die Kavitäts-Schichtsysteme aus zwei oder mehreren verschiedenen dotierten, teilweise dotierten oder undotierten organischen Schichten (hierbei kann es sich um eine paarweise oder auch nicht paarweise verschiedene Kombination handeln). Das organische Schichtsystem kann hierbei aus Mehrfachschichten, Mischschichten oder Kombinationen aus beiden bestehen.

In einer weiteren Ausführungsform des Bauelementes bestehen die Kavitäts-Schichtsysteme aus einer dotierten, teilweise dotierten oder undotierten Schicht aus Graphit, Kohlenstoff-Nanoröhrchen oder Graphenen.

In einer weiteren Ausführungsform des Bauelementes bestehen die Kavitäts-Schichtsysteme aus zwei oder mehreren verschiedenen dotierten, teilweise dotierten oder undotierten Schichten aus Graphit, Kohlenstoff-Nanoröhrchen oder Graphenen (hierbei kann es sich um eine paarweise oder auch nicht paarweise verschiedene Kombination handeln).

In einer weiteren Ausführungsform des Bauelementes bestehen die Kavitäts-Schichtsysteme aus einer Kombination von zwei oder mehreren der oben genannten Materialien.

In einer weiteren Ausführungsform des Bauelementes bestehen die Kavitäts-Schichtsysteme aus einem Material oder einem Materialsystem mit einer hohen Dielektrizitätskonstante.

In einer weiteren Ausführungsform des Bauelementes bestehen die Kavitäts-Schichtsysteme aus einem Material oder einem Materialsystem, welches ein Metamaterial ist.

Ein Metamaterial ist eine künstlich hergestellte Struktur, deren Durchlässigkeit für elektrische und magnetische Felder (Permittivität εr und Permeabilität µr) Werte aufweisen, die in der Natur üblicherweise nicht vorkommen. Von besonderem Interesse sind Metamaterialien mit reellen Brechzahlen im Bereich -∞ < n< 1. Diese Materialien absorbieren das Licht nicht und eignen sich daher besonders zur erfindungsgemäßen Verwendung als Kavitäts-Schichtsystem.

Metamaterialien sind dadurch gekennzeichnet, dass sie in ihrem Inneren speziell angefertigte mikroskopische Strukturen aus elektrischen oder magnetisch wirksamen Materialien aufweisen, die für die besonderen Eigenschaften des Materials verantwortlich sind.

Die besondere Eigenschaft von Metamaterialien besteht darin, dass die zugehörigen Materialkonstanten εr und µr negative Werte annehmen können. Das bedeutet aus der Sicht der Feldtheorie, dass das Feld der elektrischen Flussdichte (D-Feld) und das der elektrischen Feldstärke (E-Feld) sowie das Feld der magnetischen Flussdichte (B-Feld) und das Feld der magnetischen Feldstärke (H-Feld) einander entgegengesetzt gerichtet sind.

Bei den zugrundeliegenden Prozessen in Metamaterialien handelt es sich üblicherweise um Resonanzeffekte in periodische Anordnungen von Leiterelementen. Vereinfacht betrachtet besteht das Material aus einer großen Anzahl nebeneinander angeordneter elektrischer Schwingkreise mit winzigen kapazitiven und induktiven Bauelementen. Die Kapazitäten kommen durch einander gegenüberstehende metallische Leiterelemente zustande, während die induktiven Elemente die Leiterelemente selbst sind. Beispielsweise handelt es sich dabei um Nanostrukturen, meistens aus Gold oder Silber, die in Glas eingebettet werden und viel kleiner als die Wellenlänge des Lichtes sind.

Wie es bei Resonanzerscheinungen üblich ist, treten die gewünschten Effekte bei den Metamaterialien nur in einem sehr engen Frequenzbereich in Erscheinung. Den Frequenzbereich einer resonanten Struktur kann man zwar grundsätzlich durch Dämpfung vergrößern. Die Dämpfung führt jedoch gleichzeitig zu einer unerwünschten Erhöhung der Verlustleistung.

In einer weiteren Ausführungsform des Bauelementes können die Kavitäts-Schichtsysteme auch aus einer Kombinationen aus den oben genannten Materialien bzw. Strukturen (Gitter, Stäben, Streifen, geometrischen Formen) sein.

Eine weitere Ausführungsform des Bauelementes enthält neben mindestens einem Kavitäts-Schichtsystem noch eine oder zwei transparente oder teiltransparente Elektroden.

Eine weitere Ausführungsform des Bauelementes enthält mindestens ein Kavitäts-Schichtsystem und das Bauelement ist semitransparent.

In einer weiteren Ausführungsform des Bauelementes können die Kavitäts-Schichtsysteme in eine pin-Einzelzelle, pin-Tandemzelle oder pin-Mehrfachzelle (bzw. nip-Einzelzelle, nip- Tandemzelle bzw. nip-Mehrfachzelle) eingebaut sein. Hierbei können die Kavitäts-Schichtsysteme z.B. semitransparent und/oder wellenlängenabhängig und/oder polarisationssensitiv sein.

In einer weiteren Ausführungsform des Bauelementes bestehen die Kavitäts-Schichtsysteme aus chiralen Materialien. Chirale Materialien sind Materialien die die Polarisationsebene des Lichtes ändern. Allgemein ist ein Objekt chiral, wenn es keine Drehspiegelachse besitzt.

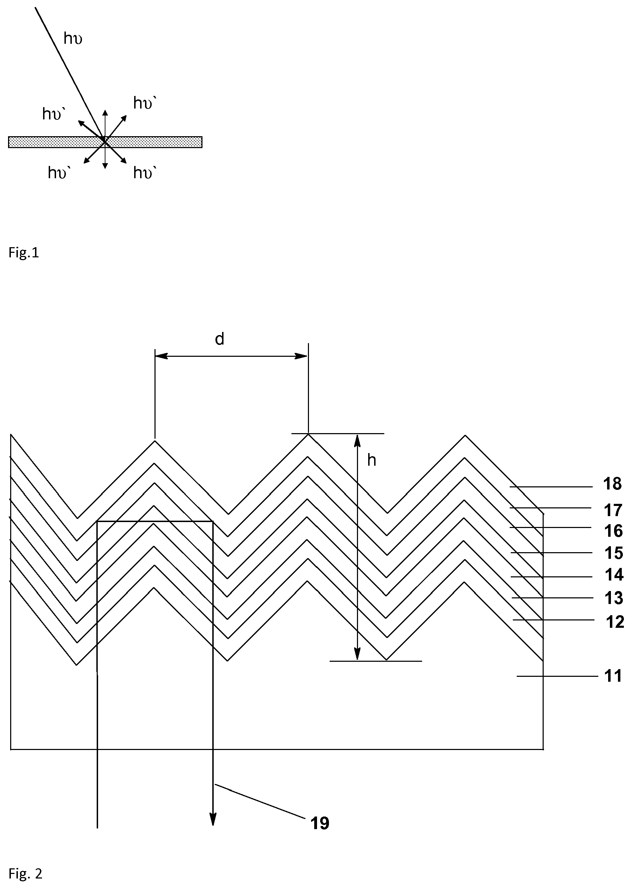

In einer weiteren Ausführungsform des Bauelementes bestehen die Kavitäts-Schichtsysteme aus fluoreszierenden oder phosphoreszierenden Materialien. Das Kavitäts-Schichtsystem fluoresziert im größeren Wellenlängenbereich im Vergleich zu seiner Absorption (Stokes-Shift), d.h. die Intensitätsverteilung des Sonnenspektrums innerhalb des Bauelementes kann verändert werden, sowie der Licht-Vektor, da die Fluoreszenz und Phosphoreszenz in alle Raumrichtungen geht (Fig.1).

Beispiele für organische fluoreszierende oder phosphoreszierende Materialien sind wie folgt:
1.)blaue Emitter:
   - Balq Bis-(2-methyl-8-quinolinolato)-4-(phenyl-phenolato)-aluminium-(III)
   - DPVBi 4,4-Bis(2,2-diphenyl-ethen-1-yl)-biphenyl
   - Spiro-DPVBi 2,2',7,7'-tetrakis(2,2-diphenylvinyl)spiro-9,9'-bifluorene
   - Spiro-Anthracene 9,10-bis(9,9'-spirobi[9H-fluorene]-2-yl)anthracene
   - DBzA 9,10-Bis[4-(6-methylbenzothiazol-2-yl)phenyl]anthracene
   - DSA-Ph 1-4-di-[4-(N,N-di-phenyl)amino]styryl-benzene
   - BCzVB 1,4-Bis[2-(3-N-ethylcarbazoryl)vinyl]benzene
2.) grüne Emitter:
   - Alq3 tris (8-hydroxy-quinolinato)-aluminium
   - C545T 2,3,6,7-Tetrahydro-1,1,7,7,-tetramethyl- 1H,5H,11H-10-(2- benzothiazolyl) quinolizino-[9,9a,1gh]coumarin
   - TPPA 9,10-Bis[N,N-di-(p-tolyl)-amino]anthracene
   - DMQA N,N'-Dimethyl-quinacridone
   Ir(ppy)3 fac tris(2-phenylpyridine) iridium (als Dotand in TCTA 4,4',4"-tris(N-carbazolyl)-triphenylamine)
3.) rote Emitter:
   - Rubren (5,6,11,12)-Tetraphenylnaphthacene
   - DCM (E)-2-(2-(4-(dimethylamino)styryl)-6-methyl-4H-pyran-4-ylidene)malononitrile
   - DCM2 4-(Dicyanomethylene)-2-methyl-6-julolidyl-9-enyl-4H-pyran
   - DCJT 4-(Dicyanomethylene)-2-methyl-6-(1,1,7,7-tetramethyljulolidyl-9-enyl)-4H-pyran
   - DCJTB 4-(Dicyanomethylene)-2-tert-butyl- 6-(1,1,7, 7-tetramethyljulolidin-4-yl-vinyl)- 4H-pyran
   Ir(piq)3 Tris(1-phenylisoquinoli-ne)iridium Ir(MDQ)2(acac) Iridium(III)bis(2-methyldibenzo-[f,h]quinoxaline)(acetylacetonate) (beide als Dotand in alpha-NPB)

In einer vorteilhaften Ausführungsform der Erfindung absorbieren die photoaktiven Schichten des Bauelementes möglichst viel Licht. Hierzu wird der Spektralbereich, in dem das Bauelement Licht absorbiert, möglichst breit gestaltet.

Das Problem von organischen Solarzellen besteht zumeist darin, dass aus elektrischen Gründen (nur eingeschränkt guter Transport für die Ladungsträger) die i-Schicht(en) nur sehr dünn gemacht werden kann (können). Dies hat zur Folge, dass nur ein Teil des Lichts im Bauelement absorbiert wird. Weiterhin sind die Absorptionsbanden von organischen Materialien begrenzt breit und haben für die meisten effizienten in Solarzellen eingesetzten Materialien typischerweise eine spektrale Breite von ca. 200nm. Dies hat zur Folge, dass die beiden Materialien, die den photoaktiven Übergang bilden (Doppelschicht oder Mischschicht) nur einen spektralen Bereich von ca. 400nm abdecken können. Eine Solarzelle mit einem sehr hohen Wirkungsgrad muss aber möglichst über den kompletten Spektralbereich von ca. 350nm bis ca. 1000nm über eine sehr hohe Absorption verfügen.

In einer vorteilhaften Ausgestaltung der obigen Ausführungsform der Erfindung besteht das i-Schichtsystem des photoaktiven Bauelementes mindestens aus zwei Mischschichten, die direkt aneinandergrenzen und mindestens eine der beiden Hauptmaterialien einer Mischschicht ein anderes organisches Material ist als die beiden Hauptmaterialien einer anderen Mischschicht. Jede Mischschicht besteht aus mindestens zwei Hauptmaterialien, wobei diese ein photoaktives Donor-Akzeptor-System bilden. Das Donor-Akzeptor-System zeichnet sich dadurch aus, dass zumindest für die Photoanregung der Donor-Komponente gilt, dass die gebildeten Exzitonen an der Grenzfläche zum Akzeptor bevorzugt in ein Loch auf dem Donor und ein Elektron auf dem Akzeptor getrennt werden. Als Hauptmaterial wird ein Material bezeichnet, dessen Volumen- oder Massen-Anteil in der Schicht größer als 16% ist. Weitere Materialien können technisch bedingt oder aber zur Einstellung von Schichteigenschaften beigemischt sein. Bereits bei einer Doppelmischschicht enthält das Bauelement drei bzw. vier verschiedene Absorbermaterialien, kann damit einen Spektralbereich von ca. 600nm bzw. ca. 800nm abdecken und somit die gestellte Aufgabe erfüllen.

In einer weiteren Ausführung der Erfindung kann die Doppelmischschicht auch dazu benutzt werden, für einen bestimmten Spektralbereich deutlich höhere Photoströme zu erzielen, indem Materialien gemischt werden, die bevorzugt in demselben Spektralbereich absorbieren. Dies kann dann im Weiteren benutzt werden, um in einer Tandemsolarzelle oder Mehrfachsolarzelle eine Stromanpassung zwischen den verschiedenen Teilzellen zu erreichen. Damit ist neben der Verwendung der Kavitätsschicht eine weitere Möglichkeit der Anpassung der Ströme der Teilzellen gegeben.

In einer weiteren Ausführungsform der Erfindung können zur Verbesserung der Ladungsträgertransporteigenschaften der Mischschichten die Mischungsverhältnisse in den verschiedenen Mischschichten gleich oder auch unterschiedlich sein.

In einer weiteren Ausführungsform der Erfindung bestehen die Mischschichten bevorzugt aus jeweils zwei Hauptmaterialien.

In einer weiteren Ausführungsform der Erfindung kann in den einzelnen Mischschichten ein Gradient des Mischungsverhältnisses vorhanden sein.

In einer bevorzugten Ausgestaltung der Erfindung ist das photoaktive Bauelement als Tandemzellen ausgeführt und es besteht durch die Verwendung von Doppel- bzw. Mehrfachmischschichten der weitere Vorteil, dass die Strom-Angleichung (current matching) zwischen den Teilzellen durch die Wahl der Absorbermaterialien in den Mischschichten optimiert und damit der Wirkungsgrad weiter erhöht werden kann.

In einer weiteren Ausführungsform der Erfindung können die einzelnen Materialien dabei in unterschiedlichen Maxima der Lichtverteilung der charakteristischen Wellenlängen, die dieses Material absorbiert, positioniert sein. So kann beispielsweise ein Material in einer Mischschicht im 2. Maximum seiner charakteristischen Wellenlänge liegen und das andere Material im 3. Maximum.

In einer weiteren Ausführungsform der Erfindung besteht das photoaktive Bauelement, insbesondere eine organische Solarzelle, aus einer Elektrode und einer Gegenelektrode und zwischen den Elektroden wenigstens zwei organischen photoaktiven Mischschichten, wobei die Mischschichten jeweils im wesentlichen aus zwei Materialien bestehen und die beiden Hauptmaterialien jeweils einer Mischschicht ein Donator-Akzeptor-System bilden sowie die beiden Mischschichten direkt aneinandergrenzen und wenigstens eine der beiden Hauptmaterialien der einen Mischschicht ein anderes organisches Material ist als die beiden Hauptmaterialien einer anderen Mischschicht.

In einer Weiterbildung der vorbeschriebenen Ausführungsform sind mehrere oder alle Hauptmaterialien der Mischschichten voneinander verschieden.

In einer weiteren Ausführungsform der Erfindung handelt es sich um drei oder mehr Mischschichten, welche zwischen der Elektrode und Gegenelektrode angeordnet sind.

In einer weiteren Ausführungsform der Erfindung sind zusätzlich zu den genannten Mischschichten noch weitere photoaktive Einzel- oder Mischschichten vorhanden.

In einer weiteren Ausführungsform der Erfindung ist zwischen dem Mischschichtsystem und der einen Elektrode noch wenigstens eine weitere organische Schicht vorhanden.

In einer weiteren Ausführungsform der Erfindung ist zwischen dem Mischschichtsystem und der Gegenelektrode noch wenigstens eine weitere organische Schicht vorhanden.

In einer weiteren Ausführungsform der Erfindung sind eine oder mehrere der weiteren organischen Schichten dotierte wide-gap Schichten, wobei das Maximum der Absorption bei < 450nm liegt.

In einer weiteren Ausführungsform der Erfindung weisen mindestens zwei Hauptmaterialien der Mischschichten verschiedene optische Absorptionsspektren auf.

In einer weiteren Ausführungsform der Erfindung weisen die Hauptmaterialien der Mischschichten verschiedene optische Absorptionsspektren auf, die sich gegenseitig ergänzen, um einen möglichst breiten Spektralbereich abzudecken.

In einer weiteren Ausführungsform der Erfindung erstreckt sich der Absorptionsbereich zumindest eines der Hauptmaterialien der Mischschichten in den Infrarot-Bereich.

In einer weiteren Ausführungsform der Erfindung erstreckt sich der Absorptionsbereich zumindest eines der Hauptmaterialien der Mischschichten in den Infrarot-Bereich im Wellenlängenbereich von >700nm bis 1500nm.

In einer weiteren Ausführungsform der Erfindung sind die HOMO- und LUMO-Niveaus der Hauptmaterialien so angepasst, dass das System eine maximale Leerlaufspannung, einen maximalen Kurzschlussstrom und einen maximalen Füllfaktor ermöglicht.

In einer weiteren Ausführungsform der Erfindung handelt es sich bei den verwendeten organischen Materialien für die Mischschichten um kleine Moleküle.

In einer weiteren Ausführungsform der Erfindung handelt es sich bei den verwendeten organischen Materialien für die Mischschichten zumindest teilweise um Polymere.

In einer weiteren Ausführungsform der Erfindung enthält mindestens eine der photoaktiven Mischschichten als Akzeptor ein Material aus der Gruppe der Fullerene bzw. Fullerenderivate (C60, C70, etc.).

In einer weiteren Ausführungsform der Erfindung enthalten alle photoaktiven Mischschichten als Akzeptor ein Material aus der Gruppe der Fullerene bzw. Fullerenderivate (C60, C70, etc.).

In einer weiteren Ausführungsform der Erfindung enthält mindestens eine der photoaktiven Mischschichten als Donator ein Material aus der Klasse der Phthalocyanine, Perylenderivate, TPD-Derivate, Oligothiophene oder ein Material wie es in WO2006092134 beschrieben ist.

In einer weiteren Ausführungsform der Erfindung enthält mindestens eine der photoaktiven Mischschichten als Akzeptor das Material Fulleren C60 und als Donator das Material 4P-TPD.

In einer weiteren Ausführungsform der Erfindung bestehen die Kontakte aus Metall, einem leitfähigen Oxid, insbesondere ITO, ZnO:Al oder anderen TCOs oder einem leitfähigen Polymer, insbesondere PEDOT:PSS oder PANI.

Im Sinne der Erfindung sind auch Polymersolarzellen, die zwei oder mehrere photoaktive Mischschichten beinhalten, wobei die Mischschichten direkt aneinandergrenzen, möglich. Bei Polymersolarzellen besteht aber das Problem das die Materialien aus Lösung aufgebracht werden und somit eine weitere aufgebrachte Schicht sehr leicht dazu führt, dass die darunter liegenden Schichten angelöst, aufgelöst oder in ihrer Morphologie verändert werden. Bei Polymersolarzellen können daher nur sehr eingeschränkt Mehrfachmischschichten hergestellt werden und auch nur dadurch, dass verschiedene Material- und Lösungsmittelsysteme verwendet werden, die sich bei der Herstellung gegenseitig nicht oder kaum beeinflussen. Solarzellen aus kleinen Molekülen haben hier einen ganz klaren Vorteil, da durch den Aufdampfprozess im Vakuum beliebige Systeme und Schichten aufeinander gebracht werden können und somit der Vorteil der Mehrfachmischschichtstruktur sehr breit genutzt und mit beliebigen Materialkombinationen realisiert werden kann. Weiterhin ist der Einbau der Mehrfachmischschichten in pin-Strukturen (oder nip) mit kontrollierter n- und p-Dotierung sehr vorteilhaft. Unter kleinen Molekülen werden im Sinne der vorliegenden Erfindung nicht-polymere organische, photoaktive Moleküle verstanden.

In Mehrfachmischschichtsystemen treten vermehrt Transportprobleme für die Ladungsträger auf. Dieser Abtransport wird durch das eingebaute Feld der pin-Struktur deutlich erleichtert. Weiterhin können die Mehrfachmischschichten innerhalb einer pin-Struktur mit dotierten wide-gap Transportschichten verschoben werden, um eine optimale Absorption zu erzielen. Hierfür kann es auch sehr vorteilhaft sein, die pin-Struktur in eine nip-Struktur zu verändern. Speziell wenn die verschiedenen Materialien in den Mehrfachmischschichten in verschiedenen Wellenlängenbereichen absorbieren, können durch eine geeignete Wahl der Struktur (pin oder nip) bzw. eine geeignete Wahl der Schichtdicken der Transportschichten die verschiedenen Materialien jeweils an die optimale Position hinsichtlich der Intensitätsverteilung des Lichtes innerhalb des Bauelementes positioniert werden. Speziell bei Tandemzellen ist diese Optimierung sehr wichtig um einen Ausgleich der Photoströme der Einzelzellen zu erreichen und somit einen maximalen Wirkungsgrad zu erreichen.

Bei nicht-polymeren organischen Materialien, so genannten kleinen Molekülen, hängt die Verdampfungstemperatur im Vakuum eng mit den intermolekularen Wechselwirkungen zusammen. Sind diese Wechselwirkungen stark ausgeprägt, führt dies zu einer erhöhten Verdampfungstemperatur.

Unter dem Begriff der Verdampfungstemperatur wird im Sinne der Erfindung diejenige Temperatur verstanden, die benötigt wird, um bei einer gegebenen Verdampfergeometrie (Referenz: Quelle mit einer kreisförmigen Öffnung (1cm Durchmesser) im Abstand von 30cm von einem senkrecht darüber angebrachten Substrat) und einem Vakuum im Bereich 10⁻⁴ bis 10⁻¹⁰ mbar eine Aufdampfrate von 0.1nm/s an der Position des Substrates zu erreichen. Hierbei ist es unerheblich, ob es sich dabei um eine Verdampfung im engeren Sinn (Übergang aus der flüssigen Phase in die Gasphase) oder eine Sublimation handelt.

Bei der Schichtbildung durch Aufdampfen entstehen daher bevorzugt solche Strukturen, bei denen die intermolekularen Wechselwirkungen innerhalb der Schicht maximiert werden, so dass die Grenzflächen, die starke Wechselwirkungen eingehen können an der Schichtoberfläche vermieden werden.

Im Fall von Mischschichten führt das dazu, dass sich an der Oberfläche bevorzugt diejenige Komponente anlagert, die vergleichsweise schwache Wechselwirkungskräfte aufweist, d.h. diese Komponente "schwimmt" bei der Schichtbildung in gewissem Umfang auf. Materialien mit vergleichsweise schwacher Wechselwirkung zwischen den Molekülen zeichnen sich normalerweise durch einen niedrigen Schmelzpunkt (z.B. < 100°C) oder eine niedrige Glasübergangstemperatur (z.B. < 150°C) aus.

Handelt es sich bei der "schwächer wechselwirkenden Komponente" um die Donatorkomponente der Mischschicht besteht eine Tendenz, dass - insbesondere bei Wachstum auf geheiztem Substrat oder bei nachträglichem Tempern - eine sehr dünne Schicht (d.h. zumindest eine Monolage) an der Oberfläche entsteht, die fast ausschließlich aus dem Donatormaterial besteht. Diese Entmischung bzw. dieses "Aufschwimmen" kann auch durch andere Prozesse wie z.B. eine Lösungsmittelbehandlung (während der Herstellung der Schicht oder nachträglich) oder durch die Methode der Abscheidung einer Schicht mittels organischen Gasphasen-Abscheidung (Organic Vapour Phase Deposition (OVPD)) entstehen bzw. unterstützt werden. Die "aufgewommene" Monolage der Donatorkomponente weist folglich schlechtere Elektronentransporteigenschaften auf und behindert den Abtransport von photogenerierten Elektronen bei einer pin-Struktur. Ein Abtransport von photogenerierten Löchern in diese Richtung ist dagegen problemlos möglich, da es sich bei der Donatorkomponente ja um ein bevorzugt löchertransportierendes Material handelt.

Das oben beschriebene Problem tritt bevorzugt dann auf, wenn das Donator-Material eine Verdampfungs-Temperatur im Vakuum hat, die um mindestens 150°C tiefer liegt als die Verdampfungs-Temperatur des Akzeptor-Materials. Durchaus möglich ist es aber auch, das bereits bei einem Verdampfungsunterschied von 100°C oder weniger, ein "Aufschwimmen" stattfindet.

In der Literatur beschriebene organische Solarzellen aus Vakuumdeposition nicht-polymerer organischer Moleküle, sogenannte kleine Moleküle, sind bis auf wenige Ausnahmen (Drechsel, Org. Electron., 5, 175 (2004); J. Drechsel, Synthet. Metal., 127, 201-205 (2002)) so aufgebaut, dass der sogenannte Grundkontakt, auf dem die organischen Schichten abgeschieden werden, die Anode bildet (falls die Struktur eine ausschließlich löcherleitende oder p-dotierte Schicht umfasst, grenzt diese an den Grundkontakt). Bei der Anode handelt es sich in der Regel um ein transparentes leitfähiges Oxid (oft Indium-Zinn-Oxid, abgekürzt ITO; es kann sich aber auch um ZnO:Al handeln), es kann aber auch eine Metallschicht oder eine Schicht aus einem leitfähigen Polymer sein. Nach Abscheidung des organischen Schichtsystems, welcher die photoaktive Mischschicht umfasst, wird eine - meist metallische - Kathode abgeschieden.

Dieser Aufbau hat zur Folge, dass die in der photoaktiven Mischschicht gebildeten Löcher zum Substrat (Anode) hin abgeführt werden müssen, während sich die photogenerierten Elektronen vom Substrat weg in Richtung auf die Kathode bewegen müssen. Dies ist aber, wie oben beschrieben, problematisch, wenn es zum "Aufschwimmen" der Donatorkomponente bei der Abscheidung oder Nachbehandlung der Mischschicht kommt.

Dieses Problem kommt umso mehr zum Tragen, je näher am thermischen Gleichgewicht das Wachstum der Mischschicht stattfindet. Der Vorteil einer verbesserten Ordnung im Volumen bei Wachstum näher am Gleichgewicht (nanokristalline statt amorphe Struktur, vgl. M. Hiramoto et al., Mol. Cryst. Liq. Cryst., 2006, 444, pp. 33-40; M. Rusu et al., Thin Solid Film, 2008, 516, pp. 7160-7166) wird deshalb durch ein zunehmendes Problem an der Grenzfläche konterkariert.

In einer weiteren Ausführungsform wird bei einer Donator-Akzeptor-Kombination, bei der zumindest ein teilweises "Aufschwimmen" des Donatormaterials in der Mischschicht stattfindet, eine invertierten Schichtfolge verwendet, wobei bei die Abscheidung auf der Kathode (n-Seite unten, z.B. n-i-p Struktur) stattfindet und die photogenerierten Elektronen die Mischschicht damit in Richtung auf das Substrat hin verlassen müssen und die photogenerierten Elektronen in Richtung der Gegenelektrode, was beides problemlos möglich ist. Dadurch wird zum einen eine gute Ordnung in der Mischschicht erzielt und gleichzeitig treten keine Transportprobleme an der Grenzfläche der Mischschicht auf.

Für die oben beschriebene invertierte Struktur (n-i-p, i-p oder n-i Struktur) kann es sein, dass im Bauelement Kontaktprobleme an der auf dem Substrat befindlichen Elektrode und /oder der Gegenelektrode auftreten: Normalerweise hat in der klassischen p-i-n Struktur die auf dem Substrat befindliche Elektrode einen Kontakt zur p-Schicht und die Gegenelektrode einen Kontakt zur n-Schicht. Diese Kontakte funktionieren sehr gut bzw. die Kontaktsysteme und Kontaktmaterialien sind inzwischen optimiert worden, so dass hier keine Verluste auftreten. Als mögliche Lösung für die invertierte Struktur können die beiden neuen Kontaktsysteme Elektrode/n-Schicht und p-Schicht/Gegenelektrode nun neu optimiert werden (z.B. durch geeignete Wahl der Materialien bzw. geeignete Herstellungsbedingungen). Eine andere Lösungsmöglichkeit besteht darin, an den Elektroden einen Konversionskontakt (pn oder np) einzubauen, so dass man wiederum die alten Kontaktsysteme Elektrode/p-Schicht und n-Schicht/Gegenelektrode erhält. Mögliche Strukturen sind hierfür z.B. pnip, nipn oder pnipn.

Eine weitere Ausführungsform des erfindungsgemäßen Bauelementes besteht darin, dass zwischen der ersten elektronenleitenden Schicht (n-Schicht) und der auf dem Substrat befindlichen Elektrode noch eine p-dotierte Schicht vorhanden ist, so dass es sich um eine pnip oder pni-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform der Erfindung kann in dem Bauelement zwischen der photoaktiven i-Schicht und der auf dem Substrat befindlichen Elektrode noch eine p-dotierte Schicht vorhanden sein, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportniveaus der i-Schicht liegt, so dass es zu verlustarmer Elektronenextraktion aus der i-Schicht in diese p-Schicht kommen kann.

Eine weitere Ausführungsform des erfindungsgemäßen Bauelementes besteht darin, dass noch ein n-Schichtsystem zwischen der p-dotierten Schicht und der Gegenelektrode vorhanden ist, so dass es sich um eine nipn oder ipn-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform kann in dem Bauelement noch ein n-Schichtsystem zwischen der intrinsischen, photoaktiven Schicht und der Gegenelektrode vorhanden sein, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt, so dass es zu verlustarmer Löcherextraktion aus der i-Schicht in diese n-Schicht kommen kann.

Eine weitere Ausführungsform des erfindungsgemäßen Bauelementes besteht darin, dass das Bauelement ein n-Schichtsystem und/oder ein p-Schichtsystem enthält, so dass es sich um eine pnipn, pnin, pipn- oder p-i-n-Struktur handelt, die sich in allen Fällen dadurch auszeichnen, dass - unabhängig vom Leitungstyp - die substratseitig an die photoaktive i-Schicht angrenzende Schicht eine geringere thermische Austrittsarbeit hat als die vom Substrat abgewandte an die i-Schicht grenzende Schicht, so dass photogenerierte Elektronen bevorzugt zum Substrat hin abtransportiert werden, wenn keine externe Spannung an das Bauelement angelegt wird.

In einer weiteren Ausführungsform der Erfindung werden mehrere Konversionskontakte hintereinandergeschaltet, so dass es sich z.B. um eine npnipn, pnipnp, npnipnp, pnpnipnpn oder pnpnpnipnpnpn Struktur handelt.

In einer bevorzugten Weiterbildung der oben beschriebenen Strukturen sind diese als organische Tandemsolarzelle oder Mehrfachsolarzelle ausgeführt. So kann es sich bei dem Bauelement um eine Tandemzelle aus einer Kombination aus nip, ni, ip, pnip, pni, pip, nipn, nin, ipn, pnipn, pnin oder pipn-Strukturen handeln, bei der mehrere unabhängige Kombinationen, die mindestens eine i-Schicht enthalten, übereinander gestapelt sind (Kreuzkombinationen).

In einer besonders bevorzugten Ausführungsform der oben beschriebenen Strukturen ist diese als eine pnipnipn-Tandemzelle ausgeführt.

Besonders wichtig in derartigen Stapelzellen ist die Balance der erzeugten Ströme in den Einzelzellen, d.h. die Anzahl der absorbierten und in Ladungsträger umgewandelten Photonen. Sollte z.B. bei einer pinpin-Tandemzelle mit zwei verschiedenen Absorbersystemen bei einer Mischschicht das oben beschriebene "Aufschwimm"-Problem auftreten, diese Mischschicht daher weniger Strom erzeugen bzw. über einen schlechteren Füllfaktor verfügen und dadurch die Tandemsolarzelle stark in ihren Eigenschaften vermindert werden (die schwächere Teilzelle limitiert mit ihrem geringeren erzeugten Strom bzw. schlechteren Füllfaktor (FF) das ganze Bauelement, d.h. auch die andere Teilzelle kann ihr Potential nicht mehr ausschöpfen) so wird das Problem erfindungsgemäß dadurch gelöst, dass zu einer invertierten nipnip-Struktur oder zu einer anderen der oben beschriebenen Strukturen gewechselt wird.

In einer weiteren Ausführungsform liegt das Akzeptor-Material in der Mischschicht zumindest teilweise in kristalliner Form vor.

In einer weiteren Ausführungsform liegt das Donator-Material in der Mischschicht zumindest teilweise in kristalliner Form vor.

In einer weiteren Ausführungsform liegen sowohl das Akzeptor-Material als auch das Donator-Material in der Mischschicht zumindest teilweise in kristalliner Form vor.

In einer weiteren Ausführungsform verfügt das Akzeptor-Material über ein Absorptionsmaximum im Wellenlängenbereich > 450nm.

In einer weiteren Ausführungsform verfügt das Donator-Material über ein Absorptionsmaximum im Wellenlängenbereich > 450nm.

In einer weiteren Ausführungsform enthält das photoaktive i-Schichtsystem zusätzlich zu der genannten Mischschicht noch weitere photoaktive Einzel- oder Mischschichten.

In einer weiteren Ausführungsform besteht das n-Materialsystem aus einer oder mehreren Schichten.

In einer weiteren Ausführungsform besteht das p-Materialsystem aus einer oder mehreren Schichten.

In einer weiteren Ausführungsform enthält das n-Materialsystem eine oder mehrere dotierte wide-gap Schichten. Der Begriff wide-gap Schichten definiert dabei Schichten mit einem Absorptionsmaximum im Wellenlängenbereich <450nm.

In einer weiteren Ausführungsform enthält das p-Materialsystem eine oder mehrere dotierte wide-gap Schichten.

In einer weiteren Ausführungsform enthält das Bauelement zwischen der ersten elektronenleitenden Schicht (n-Schicht) und der auf dem Substrat befindlichen Elektrode eine p-dotierte Schicht, so dass es sich um eine pnip oder pni-Struktur handelt.

In einer weiteren Ausführungsform enthält das Bauelement zwischen der photoaktiven i-Schicht und der auf dem Substrat befindlichen Elektrode eine p-dotierte Schicht, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportnivaus der i-Schicht liegt.

In einer weiteren Ausführungsform enthält das Bauelement ein n-Schichtsystem zwischen der p-dotierten Schicht und der Gegenelektrode, so dass es sich um eine nipn oder ipn-Struktur handelt.

In einer weiteren Ausführungsform enthält das Bauelement ein n-Schichtsystem zwischen der photoaktiven i-Schicht und der Gegenelektrode, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt.

In einer weiteren Ausführungsform enthält das Bauelement ein n-Schichtsystem und/oder ein p-Schichtsystem, so dass es sich um eine pnipn, pnin, pipn- oder p-i-n-Struktur handelt.

In einer weiteren Ausführungsform enthält das zusätzliche p-Materialsystem und/oder das zusätzliche n-Materialsystem eine oder mehrere dotierte wide-gap Schichten.

In einer weiteren Ausführungsform enthält das Bauelement noch weitere n-Schichtsysteme und/oder p-Schichtsysteme, so das es sich z.B. um eine npnipn, pnipnp, npnipnp, pnpnipnpn oder pnpnpnipnpnpn -Struktur handelt.

In einer weiteren Ausführungsform enthält eines oder mehrere der weiteren p-Materialsysteme und/oder der weiteren n-Materialsysteme eine oder mehrere dotierte wide-gap Schichten.

In einer weiteren Ausführungsform handelt es sich bei dem Bauelement um eine Tandemzelle aus einer Kombination aus nip, ni, ip, pnip, pni, pip, nipn, nin, ipn, pnipn, pnin oder pipn-Strukturen.

In einer weiteren Ausführungsform handelt es sich bei den organischen Materialien um kleine Moleküle. Unter dem Begriff kleine Moleküle werden im Sinne der Erfindung Monomere verstanden, die verdampft und damit auf dem Substrat abgeschieden werden können.

In einer weiteren Ausführungsform handelt es sich bei den organischen Materialien zumindest teilweise um Polymere, wobei aber zumindest eine photoaktive i-Schicht aus kleinen Molekülen gebildet ist.

In einer weiteren Ausführungsform ist das Akzeptor-Material ein Material aus der Gruppe der Fullerene bzw. Fullerenderivate (bevorzugt C60 oder C70) oder ein PTCDI-Derivat (Perylen-3,4,9,10-bis(dicarboximid)-Derivat).

In einer weiteren Ausführungsform ist das Donator-Material ein Oligomer, insbesondere ein Oligomer nach WO2006092134, ein Porphyrin-Derivat, ein Pentacen-Derivat oder ein Perylenderivat, wie DIP (Di-Indeno-Perylen), DBP (Di-benzoperylene).

In einer weiteren Ausführungsform enthält das p-Materialsystem ein TPD-Derivat(Triphenylamin-Dimer), eine Spiro-Verbindung, wie Spiropyrane, Spiroxazine, MeO-TPD (N,N,N',N'-Tetrakis(4-methoxyphenyl)-benzidin), Di-NPB (N,N'diphenyl-N,N'-bis(N,N'-di(1-naphthyl)-N,N'-diphenyl-(1,1'-biphenyl) 4,4'-diamine), MTDATA (4,4',4" -Tris-(N-3-methylphenyl-N-phenyl-amino)-triphenylamin), TNATA (4,4',4"-Tris[N-(1-naphthyl)-N-phenyl-amino]-triphenylamin), BPAPF (9,9-bis{4-[di-(p-biphenyl)aminophenyl]}fluorene), NPAPF (9,9-Bis[4-(N,N'-bis-naphthalen-2-yl-amino)phenyl]-9H-fluorene), Spiro-TAD (2,2',7,7'-Tetrakis-(diphenylamino)-9,9'-spirobifluoren), PV-TPD (N,N-di 4-2,2-diphenyl-ethen-1-yl-phenyl-N,N-di 4-methylphenylphenylbenzidine), 4P-TPD (4,4'-bis-(N,N-diphenylamino)-tetraphenyl), oder ein in DE102004014046 beschriebenes p-Material.

In einer weiteren Ausführungsform enthält das n-Materialsystem Fullerene, wie beispielsweise C60, C70; NTCDA (1,4,5,8-Naphthalene-tetracarboxylic-dianhydride), NTCDI (Naphthalenetetracarboxylic diimide) oder PTCDI (Perylen-3,4,9,10-bis(dicarboximid).

In einer weiteren Ausführungsform enthält das p-Materialsystem einen p-Dotanden, wobei dieser p-Dotand F4-TCNQ, ein p-Dotand wie in DE10338406, DE10347856, DE10357044, DE102004010954, DE102006053320, DE102006054524 und DE102008051737 beschrieben oder ein Übergangsmetalloxid (VO, WO, MoO, etc.) ist.

In einer weiteren Ausführungsform enthält das n-Materialsystem einen n-Dotanden, wobei dieser n-Dotand ein TTF-Derivat (Tetrathiafulvalen-Derivat) oder DTT-Derivat (dithienothiophen), ein n-Dotand wie in DE10338406, DE10347856, DE10357044, DE102004010954, DE102006053320, DE102006054524 und DE102008051737 beschrieben oder Cs, Li oder Mg ist.

In einer weiteren Ausführungsform ist eine Elektrode transparent mit einer Transmission > 80% und die andere Elektrode reflektierend mit einer Reflektion > 50% ausgeführt.

In einer weiteren Ausführungsform ist das Bauelement semitransparent mit einer Transmission von 10-80% ausgeführt.

In einer weiteren Ausführungsform bestehen die Elektroden aus einem Metall (z.B. Al, Ag, Au oder eine Kombination aus diesen), einem leitfähigen Oxid, insbesondere ITO, ZnO:Al oder einem anderen TCO (Transparent Conductive Oxide), einem leitfähigen Polymer, insbesondere PEDOT/PSS Poly(3,4-ethylenedioxythiophene)poly(styrenesulfonate) oder PANI (Polyanilin), oder aus einer Kombination aus diesen Materialien.

In einer weiteren Ausführungsform weisen die verwendeten organischen Materialien einen niedrigem Schmelzpunkt, bevorzugt < 100°C, auf.

In einer weiteren Ausführungsform weisen die verwendeten organischen Materialien eine niedrige Glasübergangstemperatur, bevorzugt < 150°C, auf.

In einer weiteren Ausführungsform der Erfindung wird durch Verwendung von Lichtfallen der optische Weg des einfallenden Lichtes im aktiven System vergrößert.

In einer weiteren Ausführungsform der Erfindung ist das Bauelement als organische pin-Solarzelle bzw. organische pin-Tandemsolarzelle ausgeführt. Als Tandemsolarzelle wird dabei eine Solarzelle bezeichnet, die aus einem vertikalen Stapel zweier in Serie verschalteter Solarzellen besteht.

In einer weiteren Ausführungsform wird die Lichtfalle dadurch realisiert, dass das Bauelement auf einem periodisch mikrostrukturierten Substrat aufgebaut wird und die homogene Funktion des Bauelements, also eine kurzschlussfreie Kontaktierung und homogene Verteilung des elektrischen Feldes über die gesamte Fläche, durch die Verwendung einer dotierten wide-gap-Schicht gewährleistet wird. Ultradünne Bauelemente weisen auf strukturierten Substraten eine erhöhten Gefahr zur Bildung lokaler Kurzschlüsse auf, so dass durch eine solche offensichtliche Inhomogenität letztlich die Funktionalität des gesamten Bauelements gefährdet ist. Diese Kurzschlussgefahr wird durch die Verwendung der dotierten Transportschichten verringert.

In einer weiteren Ausführungsform der Erfindung wird die Lichtfalle dadurch realisiert, dass das Bauelement auf einem periodisch mikrostrukturierten Substrat aufgebaut wird und die homogene Funktion des Bauelementes, dessen kurzschlussfreie Kontaktierung und eine homogene Verteilung des elektrischen Feldes über die gesamte Fläche durch die Verwendung einer dotierten wide-gap-Schicht gewährleistet wird. Besonders vorteilhaft ist dabei, dass das Licht die Absorberschicht mindestens zweimal durchläuft, was zu einer erhöhten Lichtabsorption und dadurch zu einem verbesserten Wirkungsgrad der Solarzelle führen kann. Dies lässt sich beispielsweise (Fig. 2) dadurch erreichen, dass das Substrat pyramidenartige Strukturen auf der Oberfläche aufweist mit Höhen (h) und Breiten (d) jeweils im Bereich von einem bis zu mehreren hundert Mikrometern. Höhe und Breite können gleich oder unterschiedlich gewählt werden. Ebenfalls können die Pyramiden symmetrisch oder asymmetrisch aufgebaut sein.

In einer weiteren Ausführungsform der Erfindung wird die Lichtfalle dadurch realisiert, dass eine dotierte wide-gap-Schicht eine glatte Grenzfläche zur i-Schicht und eine rauhe Grenzfläche zum reflektierenden Kontakt hat. Die rauhe Grenzfläche kann beispielsweise durch eine periodische Mikrostrukturierung erreicht werden. Besonders vorteilhaft ist die rauhe Grenzfläche, wenn sie das Licht diffus reflektiert, was zu einer Verlängerung des Lichtweges innerhalb der photoaktiven Schicht führt.

In einer weiteren Ausführungsform wird die Lichtfalle dadurch realisiert, dass das Bauelement auf einem periodisch mikrostrukturierten Substrat aufgebaut wird und eine dotierte wide-gap-Schicht eine glatte Grenzfläche zur i-Schicht und eine rauhe Grenzfläche zum reflektierenden Kontakt hat.

In einer weiteren Ausführungsform der Erfindung ist die Gesamtstruktur mit transparentem Grund- und Deckkontakt versehen.

In einer weiteren Ausführungsform werden die erfindungsgemäßen photoaktiven Bauelemente auf gekrümmten Oberflächen, wie beispielsweise Beton, Dachziegeln, Ton, Autoglas, etc. verwendet. Dabei ist es vorteilhaft, dass die erfindungsgemäßen organischen Solarzellen gegenüber herkömmlichen anorganischen Solarzellen auf flexiblen Trägern wie Folien, Textilen, etc. aufgebracht werden können.

In einer weiteren Ausführungsform werden die erfindungsgemäßen photoaktiven Bauelemente auf eine Folie oder Textil aufgebracht, welche auf der, mit dem erfindungsgemäßen organischen Schichtsystem gegenüberliegenden Seite ein Adhäsionsmittel, wie beispielsweise einen Klebstoff aufweist. Dadurch ist es möglich eine Solarklebefolie herzustellen, welche nach Bedarf auf beliebigen Oberflächen angeordnet werden kann. So kann eine selbsthaftende Solarzelle erzeugt werden.

In einer weiteren Ausführungsform weisen die erfindungsgemäßen photoaktiven Bauelemente ein anderes Adhäsionsmittel in Form einer Klettverschlussverbindung auf.

In einer weiteren Ausführungsform werden die erfindungsgemäßen photoaktiven Bauelemente in Verbindung mit Energiepuffer bzw. Energiespeichermedium wie beispielsweise Akkus, Kondensatoren, etc. zum Anschluss an Verbraucher bzw. Geräte verwendet.

In einer weiteren Ausführungsform werden die erfindungsgemäßen photoaktiven Bauelemente in Kombination mit Dünnfilmbatterien verwendet.

In einer weiteren Ausführungsform werden die erfindungsgemäßen photoaktiven Bauelemente auf gekrümmten Oberflächen, wie beispielsweise Beton, Dachziegeln, Ton, Autoglas, etc. verwendet. Dabei ist es vorteilhaft, dass die erfindungsgemäßen organischen Solarzellen gegenüber herkömmlichen anorganischen Solarzellen auf flexiblen Trägern wie Folien, Textilen, etc. aufgebracht werden können.

In einer weiteren Ausführungsform werden die erfindungsgemäßen photoaktiven Bauelemente auf eine Folie oder Textil aufgebracht, welche auf der, mit den erfindungsgemäßen organischen Schichtsystem gegenüberliegenden Seite ein Adhäsionsmittel, wie beispielsweise einen Klebstoff aufweist. Dadurch ist es möglich eine Solarklebefolie herzustellen, welche nach Bedarf auf beliebigen Oberflächen angeordnet werden kann. So kann eine selbsthaftende Solarzelle erzeugt werden.

In einer weiteren Ausführungsform weisen die erfindungsgemäßen organischen Solarzellen ein anderes Adhäsionsmittel in Form einer Klettverschlussverbindung auf.

Nachfolgend soll die Erfindung anhand einiger Ausführungsbeispiele und Figuren eingehend erläutert werden. Es zeigen in
Fig. 1 eine schematische Darstellung der veränderten Intensitätsverteilung des Sonnenspektrums innerhalb des Bauelementes, sowie des Licht-Vektors, wobei die Fluoreszenz und Phosphoreszenz in alle Raumrichtungen geht,
Fig. 2 die schematische Darstellung einer Struktur eines beispielhaften photoaktiven Bauelements auf mikrostrukturiertem Substrat,
Fig. 3 eine schematische Darstellung des Querschnitts eines erfindungsgemäßen Bauelements mit einem Kavitätsschichtsystem,
Fig. 4 eine schematische Darstellung des Querschnitts eines erfindungsgemäßen Bauelements, und in
Fig. 5 eine Darstellung der Stabilitätskurven eines erfindungsgemäßen Bauelements mit Passivierungsschicht im Vergleich zu einem photoaktiven Bauelement entsprechend des Stands der Technik.

### Ausführungsbeispiele:

In einem ersten Ausführungsbeispiel der Erfindung wird in Fig.2 eine Lichtfalle zur Verlängerung des optischen Wegs des einfallenden Lichtes im aktiven System verwendet.

Dabei wird die Lichtfalle dadurch realisiert, dass das Bauelement auf einem periodisch mikrostrukturierten Substrat aufgebaut wird und die homogene Funktion des Bauelementes, dessen kurzschlussfreie Kontaktierung und eine homogene Verteilung des elektrischen Feldes über die gesamte Fläche durch die Verwendung einer dotierten wide-gap-Schicht gewährleistet wird. Besonders vorteilhaft ist dabei, dass das Licht die Absorberschicht mindestens zweimal durchläuft, was zu einer erhöhten Lichtabsorption und dadurch zu einem verbesserten Wirkungsgrad der Solarzelle führen kann. Dies lässt sich beispielsweise wie in Fig. 2 dadurch erreichen, dass das Substrat pyramidenartige Strukturen auf der Oberfläche aufweist mit Höhen (h) und Breiten (d) jeweils im Bereich von einem bis zu mehreren hundert Mikrometern. Höhe und Breite können gleich oder unterschiedlich gewählt werden. Ebenfalls können die Pyramiden symmetrisch oder asymmetrisch aufgebaut sein. Die Breite der pyramidenartigen Strukturen liegt hierbei zwischen 1µm und 200µm. Die Höhe der pyramidenartigen Strukturen kann zwischen 1µm und 1mm liegen.

Bezeichnung Fig. 2:
1µm < d < 200µm
1µm < h < 1mm
   11: Substrat
   12: Elektrode; z.B. ITO oder Metall (10 - 200nm)
   13: HTL oder ETL-Schichtsystem (10 - 200nm)
   14: Absorbermischschicht 1 (10 - 200nm)
   15: Absorbermischschicht 2 (10 - 200nm)
   16: HTL oder ETL-Schichtsystem (10 - 200nm)
   17: Passivierungsschicht (1nm - 200nm)
   18: Elektrode; z.B. ITO oder Metall (10 - 200nm)
   19: Weg des einfallenden Lichts

In einem weiteren Ausführungsbeispiel weist das erfindungsgemäße photoaktive Bauelement den nachfolgenden Beispielaufbau auf:
1. Elektrode
2. Passivierungsschicht
3. p-Transportschichtsystem
4. photoaktives Schichtsystem 1
5. n- Transportschichtsystem
6. Kavitäts-Schichtsystem (z.B. semitransparent und/oder wellenlängenabhängig und/oder polarisationssensitiv)
7. p-Transportschichtsystem
8. photoaktives Schichtsystem 2
9. n- Transportschichtsystem
10. Elektrode

In einem weiteren Ausführungsbeispiel weist das erfindungsgemäße photoaktive Bauelement, als eine pin-Tandemzelle oder pin-Mehrfachzelle, wobei eine oder mehrere Transportschichten fehlen, den nachfolgenden Beispielaufbau auf:
1. Elektrode
2. Passivierungsschicht
3. p-Transportschichtsystem
4. photoaktives Schichtsystem 1
5. Kavitäts-Schichtsystem (z.B. semitransparent und/oder wellenlängenabhängig und/oder polarisationssensitiv)
6. p-Transportschichtsystem
7. photoaktives Schichtsystem 2
8. n- Transportschichtsystem
9. Elektrode

Oder:
1. Elektrode
2. Passivierungsschicht
3. p-Transportschichtsystem
4. photoaktives Schichtsystem 1
5. n- Transportschichtsystem
6. Kavitäts-Schichtsystem (z.B. semitransparent und/oder wellenlängenabhängig und/oder polarisationssensitiv)
7. photoaktives Schichtsystem 2
8. n- Transportschichtsystem
9. Elektrode

Oder:
1. Elektrode
2. p-Transportschichtsystem
3. photoaktives Schichtsystem 1
4. Kavitäts-Schichtsystem (z.B. semitransparent und/oder wellenlängenabhängig und/oder polarisationssensitiv)
5. photoaktives Schichtsystem 2
6. n- Transportschichtsystem
7. Passivierungsschicht
8. Elektrode

In einem weiteren Ausführungsbeispiel weist das erfindungsgemäße photoaktive Bauelement, als eine pin-Tandemzelle oder pin-Mehrfachzelle, wobei sich mindestens ein Kavitäts-Schichtsystem innerhalb eines der photoaktiven Systeme befindet, den nachfolgenden Beispielaufbau auf:
1. Elektrode
2. Passivierungsschicht
3. p-Transportschichtsystem
4. Kombination aus photoaktives Schichtsystem 1 und Kavitäts-Schichtsystem (z.B. semitransparent und/oder wellenlängenabhängig und/oder polarisationssensitiv)
5. n- Transportschichtsystem (kann ggf. auch wegfallen)
6. p-Transportschichtsystem (kann ggf. auch wegfallen)
7. photoaktives Schichtsystem 2
8. n- Transportschichtsystem
9. Elektrode

Oder:
1. Elektrode
2. Passivierungsschicht
3. p-Transportschichtsystem
4. photoaktives Schichtsystem 1
5. n- Transportschichtsystem (kann ggf. auch wegfallen)
6. p-Transportschichtsystem (kann ggf. auch wegfallen)
7. Kombination aus photoaktives Schichtsystem 2 und Kavitäts-Schichtsystem (z.B. semitransparent und/oder wellenlängenabhängig und/oder polarisationssensitiv)
8. n- Transportschichtsystem
9. Elektrode

In einem weiteren Ausführungsbeispiel weist das erfindungsgemäße photoaktive Bauelement, als eine pin-Tandemzelle oder pin-Mehrfachzelle, wobei sich mindestens ein Kavitäts-Schichtsystem an einer der Elektroden befindet, den nachfolgenden Beispielaufbau auf:
1. Elektrode
2. Passivierungsschicht
3. Kavitäts-Schichtsystem (z.B. semitransparent und/oder wellenlängenabhängig und/oder polarisationssensitiv)
4. p-Transportschichtsystem (kann ggf. auch wegfallen)
5. photoaktives Schichtsystem 1
6. n- Transportschichtsystem
7. p-Transportschichtsystem
8. photoaktives Schichtsystem 2
9. n- Transportschichtsystem
10. Elektrode

oder:
1. Elektrode
2. Kavitäts-Schichtsystem (z.B. semitransparent und/oder wellenlängenabhängig und/oder polarisationssensitiv)
3. Passivierungsschicht
4. p-Transportschichtsystem (kann ggf. auch wegfallen)
5. photoaktives Schichtsystem 1
6. n- Transportschichtsystem
7. p-Transportschichtsystem
8. photoaktives Schichtsystem 2
9. n- Transportschichtsystem
10. Elektrode

oder:
1. Elektrode
2. Passivierungsschicht
3. p-Transportschichtsystem
4. photoaktives Schichtsystem 1
5. n- Transportschichtsystem
6. p-Transportschichtsystem
7. photoaktives Schichtsystem 2
8. n- Transportschichtsystem (kann ggf. auch wegfallen)
9. Kavitäts-Schichtsystem (z.B. semitransparent und/oder wellenlängenabhängig und/oder polarisationssensitiv)
10. Elektrode

In einem weiteren Ausführungsbeispiel weist das erfindungsgemäße photoaktive Bauelement folgende Schichtreihenfolge auf:
1. Elektrode
2. Passivierungsschicht
3. Kavitäts-Schichtsystem (z.B. semitransparent und/oder wellenlängenabhängig und/oder polarisationssensitiv)
4. p-Transportschichtsystem
5. photoaktives Schichtsystem 1
6. n- Transportschichtsystem
7. p-Transportschichtsystem
8. photoaktives Schichtsystem 2
9. n- Transportschichtsystem (kann ggf. auch wegfallen)
10. Elektrode

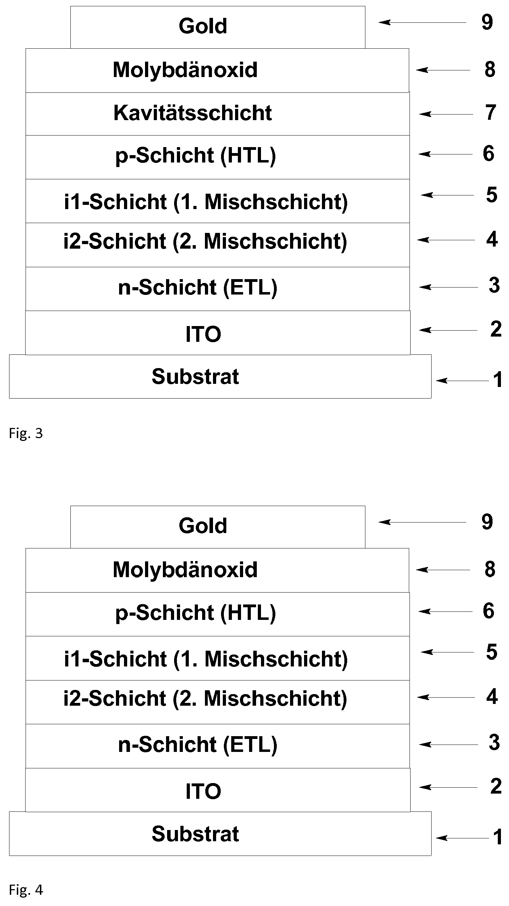

In einem weiteren Ausführungsbeispiel weist das erfindungsgemäße photoaktive Bauelement in Fig. 3 folgende Schichtreihenfolge auf:
Glas-Substrat **1,**
ITO Grundkontakt **2,**
Elektronentransportschicht (ETL) **3,**
aktives i-Doppel-Schichtsystem 4P-TPD:C60 / DCV6T:C60 **4,5,**
p-dotierte Löchertransportschicht (HTL) **6,**
Kavitäts-Schichtsystem (z.B. semitransparent und/oder wellenlängenabhängig und/oder polarisationssensitiv) **7,**
Passivierungsschicht (Molybdänoxid) **8,**
Deckkontakt (z.B. Gold) **9.**

In einem weiteren Ausführungsbeispiel weist das erfindungsgemäße photoaktive Bauelement in Fig. 4 folgende Schichtreihenfolge auf:
Glas-Substrat **1,**
ITO Grundkontakt **2,**
Elektronentransportschicht (ETL) **3,**
aktives i-Doppel-Schichtsystem 4P-TPD:C60 / DCV6T:C60 **4,5,**
p-dotierte Löchertransportschicht (HTL) **6,**
Passivierungsschicht (Molybdänoxid) **8,**
Deckkontakt (z.B. Gold) **9.**

In einem weiteren Ausführungsbeispiel weist das erfindungsgemäße photoaktive Bauelement folgende Schichtreihenfolge auf:
"ohne Metalloxid" (Referenzprobe nach Stand der Technik):
   Glas / ITO / Ladungstransportschicht 1 / Ladungstransportschicht 2 / Absorber-Mischschicht / Ladungstransportschicht 3 / Ladungstransportschicht 4 / Aluminium.
"mit Metalloxid" (erfindungsgemäßes Ausführungsbeispiel):
   Glas / ITO / Ladungstransportschicht 1 / Ladungstransportschicht 2 / Absorber-Mischschicht / Ladungstransportschicht 3 / Ladungstransportschicht 4 / Metalloxid / Aluminium.

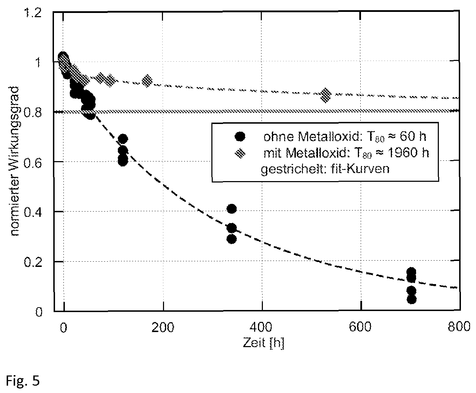

In der dazugehörigen Fig. 5 sind die Stabilitätskurven über die Zeit der photoaktiven Bauelemente mit und ohne einer Passivierungsschicht aus einem Metalloxid dargestellt. Wie der Fig. 5 entnommen werden kann, weisen die photoaktiven Bauelemente mit Passivierungsschicht eine längere Lebensauer auf.

### Bezugzeichenliste

- 1: Substrat
- 2: Grundkontakt (Elektrode)
- 3: Elektronentransportschicht (ETL)
- 4: aktives i-Doppel-Schichtsystem 1
- 5: aktives i-Doppel-Schichtsystem 2
- 6: p-dotierte Löchertransportschicht (HTL)
- 7: Kavitäts-Schichtsystem (8 Passivierungsschicht
- 9: Deckkontakt (Elektrode)
- 10: Elektrode
- 11: Substrat
- 12: Elektrode
- 13: HTL oder ETL-Schichtsystem
- 14: Absorbermischschicht 1
- 15: Absorbermischschicht 2
- 16: HTL oder ETL-Schichtsystem
- 17: Passivierungsschicht
- 18: Elektrode
- 19: Weg des einfallenden Lichts

## Patentansprüche

1. Organische Einfach-, Tandem- oder Mehrfachsolarzelle mit zwei Elektroden(2, 9), wobei eine Elektrode (2) auf einem Substrat (1) und eine als Top-Gegenelektrode (9) angeordnet ist und zwischen den Elektroden (2, 9) ein photoaktives Schichtsystem (4, 5), sowie zumindest eine undotierte, teilweise dotierte oder dotierte Ladungsträgertransportschicht( 3, 6), welche zwischen einer der Elektroden (2, 9) und dem photoaktiven Schichtsystem (4, 5) angeordnet ist,
**dadurch gekennzeichnet, dass**
sich zwischen dem photoaktiven Schichtsystem (4, 5) und der Top-Gegenelektrode (9) eine Passivierungsschicht (8) bestehend aus Molybdänoxid oder aus ganz oder teilweise dotiertem Molybdänoxid befindet, und
wobei die Passivierungsschicht (8) direkt an die Top-Gegenelektrode (9) angrenzt, sich innerhalb der Top-Gegenelektrode (9) befindet oder dass sich zwischen der Passivierungsschicht (8) und der Top-Gegenelektrode (9) sich noch mindestens eine weitere Schicht (7) befindet, und
wobei die Passivierungsschicht (8) direkt an eine dotierte, teilweise dotierte oder undotierte Transportschicht (6) grenzt.

2. Photoaktives Bauelement nach Anspruch 1, **dadurch gekennzeichnet, dass** weiterhin innerhalb zumindest einer der Zellen oder zumindest zwischen zwei benachbarten Zellen zumindest ein Kavitäts-Schichtsystem (7) angeordnet ist, welches die optische Feldverteilung innerhalb des Bauelementes verändert.

3. Organische Solarzelle nach einem der vorhergehenden Ansprüche, **dadurch gekennzeichnet, dass** es sich bei dem Bauelement um eine pin-Einzel, pin-Tandemzelle ,pin-Mehrfachzelle, nip-Einzelzelle, nip- Tandemzelle oder nip-Mehrfachzelle handelt.

4. Organische Solarzelle nach einem der vorhergehenden Ansprüche, **dadurch gekennzeichnet, dass** die Top-Gegenelektrode aus einem Metall, einem transparenten leitfähigen Oxid, aus einer dotierten organischen Schicht, aus organischen Kristallen, einem leitfähigen Polymer, aus einem luftsensitiven Elektrodenmaterial oder aus Kombinationen der vorgenannten Materialien besteht.

5. Organische Solarzelle nach einem der vorhergehenden Ansprüche, **dadurch gekennzeichnet, dass** das Bauelement aus einer Kombination aus nip, ni, ip, pnip, pni, pip, nipn, nin, ipn, pnipn, pnin oder pipn-Strukturen besteht, bei der mehrere unabhängige Kombinationen, die mindestens eine i-Schicht enthalten, übereinander gestapelt sind.

6. Organische Solarzelle nach einem der vorhergehenden Ansprüche, **dadurch gekennzeichnet, dass** die Schichten des Schichtsystems des Bauelements als eine den optischen Weg des einfallenden Lichts verlängernde Lichtfalle ausgebildet sind.

7. Organische Solarzelle nach einem der vorhergehenden Ansprüche, **dadurch gekennzeichnet, dass** das photoaktive Bauelement auf flexiblen Trägermaterialien angeordnet ist, welche auf gekrümmten oder flexiblen Trägerflächen anordbar sind.

8. Organische Solarzelle nach einem der vorhergehenden Ansprüche, **dadurch gekennzeichnet, dass** die organischen Schichten zumindest teilweise aus kleinen Molekülen, zumindest teilweise aus Polymeren oder aus einer Kombination von kleinen Molekülen und Polymeren bestehen.

9. Organische Solarzelle nach einem der vorhergehenden Ansprüche, **dadurch gekennzeichnet, dass** das Bauelement zumindest in einem gewissen Lichtwellenlängenbereich semitransparent ist.

10. Verwendung einer organischen Solarzelle gemäß einem der Ansprüche 1 bis 9 auf ebenen, gekrümmten oder flexiblen Trägerflächen.

## Claims

1. An organic single, tandem or multiple solar cell comprising two electrodes (2, 9), wherein one electrode (2) is arranged on a substrate (1) and one electrode is arranged as a top-counterelectrode (9) and between the two electrodes (2, 9) there is a photoactive layer system (4, 5), such as at least one undoped, partly doped or doped charge carrier transport layer (3, 6), which is arranged between one of the electrodes (2, 9) and the photoactive layer system (4,5), **characterized in that**
a passivation layer (8) composed of molybdenum oxide, or wholly or partly doped molybdenum oxide, which is arranged between the photoactive layer system and the top-counterelectrode (9), and wherein the passivation layer (8) adjoins directly to the top-counterelectrode (9), or is situated within the top-counterelectrode (9) or **in that** at least one further layer(7), is additionally arranged between the passivation layer (8) and the top-counterelectrode(9), and wherein the passivation layer (8) adjoins directly to a doped or partly doped charge carrier transport layer (6).

2. The organic solar cell according to claim 1, **characterized in that** at least one cavity layer system (7) is furthermore arranged within at least one of the cells or at least between two adjacent cells, and alters the optical field distribution within the component.

3. The organic solar cell according to any of the precending claims, wherein the component is a pin-single, pin-tandem cell, pin-multiple cell, nip single cell, nip-tandem cell or nip-multiple cell.

4. The organic solar cell according to any of the precending claims, wherein the top counterelectrode consists of a metal, a transparent conductive oxide, of a doped organic layer, of organic crystals, a conductive polymer, of an air-sensitive electrode material or of combinations of the aforementioned materials.

5. The organic solar cell according to any of the precending claims, wherein the component consists of a combination of nip, ni, ip, pnip, pni, pip, nipn, nin, ipn, pnipn, pnin or pipn-structures, in which a plurality of independent combinations containing at least one i-layer are stacked one above another.

6. The organic solar cell according to any of the precending claims, wherein the layers of the layer system of the component are embodied as a light trap that lengthens the optical path of the incident light.

7. The organic solar cell according to any of the precending claims, wherein the organic solar cell is arranged on flexible carrier materials which can be arranged on curved or flexible carrier surfaces.

8. The organic solar cell according to any of the precending claims, wherein the organic layers consist at least partly of small molecules, at least partly of polymers or of a combination of small molecules and polymers.

9. The organic solar cell according to any of the precending claims, wherein the component is semitransparent at least in a certain light wavelength range.

10. The use of an organic solar cell according to any of the claims 1 to 9 on planar, curved or flexible carrier surfaces.

## Revendications

1. Cellule solaire organique simple, tandem ou multiple, comportant deux électrodes (2, 9), dans laquelle une électrode (2) est disposée sur un substrat (1) et une autre en tant que contre-électrode supérieure (9), et, entre les électrodes (2, 9), un système de couches photoactives (4, 5), ainsi qu'au moins une couche (3, 6) de transport de porteurs de charge, non-dopée, partiellement dopée ou dopée, qui est disposée entre l'une des électrodes (2, 9) et le système de couches photoactives (4, 5), **caractérisée en ce qu'**entre le système de couches photoactives (4, 5) et la contre-électrode supérieure (9) se trouve une couche de passivation (8) constituée d'oxyde de molybdène, ou d'oxyde de molybdène entièrement ou partiellement dopé, et la couche de passivation (8) étant directement contiguë à la contre-électrode supérieure (9), et se trouvant à l'intérieur de la contre-électrode supérieure (9), ou qu'entre la couche de passivation (8) et la contre-électrode supérieure (9) se trouve encore au moins une couche supplémentaire (7), et la couche de passivation (8) étant directement contiguë à une couche de transport (6) dopée, partiellement dopée ou non dopée.

2. Composant photoactif selon la revendication 1, **caractérisé en ce qu'**au moins un système de couches à cavités (7), qui modifie la répartition du champ optique à l'intérieur du composant, est disposé en outre à l'intérieur d'au moins l'une des cellules ou au moins entre deux cellules voisines.

3. Cellule solaire organique selon l'une des revendications précédentes, **caractérisée en ce que**, pour ce qui concerne le composant, il s'agit d'une pin simple, d'une cellule pin tandem, d'une cellule pin multiple, d'une cellule nip simple, d'une cellule nip tandem ou d'une cellule nip multiple.

4. Cellule solaire organique selon l'une des revendications précédentes, **caractérisée en ce que** la contre-électrode supérieure est constituée d'un métal, d'un oxyde conducteur transparent, d'une couche organique dopée, de cristaux organiques, d'un polymère conducteur, d'un matériau d'électrode sensible à l'air ou d'une combinaison des matériaux mentionnés ci-dessus.

5. Cellule solaire organique selon l'une des revendications précédentes, **caractérisée en ce que** le composant est constitué d'une combinaison de structures nip, ni, ip, pnip, pni, pip, nipn, nin, ipn, pnipn, pnin ou pipn, dans laquelle de nombreuses combinaisons indépendantes, qui contiennent au moins une couche i, sont empilées les unes sur les autres.

6. Cellule solaire organique selon l'une des revendications précédentes, **caractérisée en ce que** les couches du système de couches du composant sont conçues comme un piège de lumière, qui allonge le chemin optique de la lumière incidente.

7. Cellule solaire organique selon l'une des revendications précédentes, **caractérisée en ce que** le composant photoactif est disposé sur des matériaux supports souples, qui peuvent être disposés sur des surfaces supports courbes ou souples.

8. Cellule solaire organique selon l'une des revendications précédentes, **caractérisée en ce que** les couches organiques sont au moins partiellement constituées de petites molécules, au moins partiellement de polymères ou d'une combinaison de petites molécules et de polymères.

9. Cellule solaire organique selon l'une des revendications précédentes, **caractérisée en ce que** le composant est semi-transparent au moins dans une certaine gamme de longueurs d'ondes.

10. Utilisation d'une cellule solaire organique selon l'une des revendications 1 à 9 sur des surfaces supports planes, courbes ou souples.
